# EUROPEAN PATENT SPECIFICATION

(11) **EP 3 355 462 B1**
(45) Date of publication and mention of the grant of the patent: **18.12.2024**
(21) Application number: 16848308.9
(22) Date of filing: 14.09.2016
(51) Int. Cl.: G01R 31/327, H02H 7/08, H02P 27/08

(54) **MOTOR CONTROL DEVICE**
MOTORSTEUERUNGSVORRICHTUNG
DISPOSITIF DE COMMANDE DE MOTEUR

(30) Priority: 25.09.2015 JP 2015187775
(43) Date of publication of application: 01.08.2018
(73) Proprietor: Panasonic Intellectual Property Management Co., Ltd., Osaka-shi, Osaka 540-6207 (JP)
(72) Inventor: KISHIBE, Taro, Osaka-shi, Osaka 540-6207 (JP); WATABE, Ryuhei, Osaka-shi, Osaka 540-6207 (JP); ICHIKAWA, Hideaki, Osaka-shi, Osaka 540-6207 (JP); SONODA, Daisuke, Osaka-shi, Osaka 540-6207 (JP)
(74) Representative: SSM Sandmair
(86) International application number: PCT/JP2016/004176
(87) International publication number: WO 2017/051517

(56) References cited:
- EP-A1- 2 341 609
- WO-A1-2015/145610
- JP-A- 2009 217 848
- JP-A- 2010 284 051
- JP-A- 2013 247 693
- JP-A- 2013 247 693
- JP-B1- 5 615 470

## Description

### TECHNICAL FIELD

The present invention relates to a motor control device provided with an energization cut-off circuit that cuts off energization of electric power to a motor based on an external command. In particular, the present invention relates to a motor control device also provided with a diagnosis function that detects abnormality of this energization cut-off circuit by diagnosing the energization cut-off circuit.

### BACKGROUND ART

In recent years, pulse width modulation (PWM) control that utilizes digital processing using a microprocessor has been widely performed in a motor control system. As an example of such motor control, there is a motor control technique using proportional and integral control (PI control) or the like. In other words, a motor current flowing in a winding of a motor is detected for every period of switching timing in the PWM, and the detected motor current is controlled so as to match a current command value, for example. Further, torque output from a Surface Permanent Magnet Synchronous Motor used in an FA servo is proportional to the motor current. Accordingly, the torque output from the motor can be freely controlled by controlling a value of the motor current by the PWM control.

On the other hand, conventionally, there has been proposed a technique that includes an emergency stop circuit that stops a motor during an emergency, and further, that reduces a failure risk of this emergency stop circuit (for example, see PTL 1).

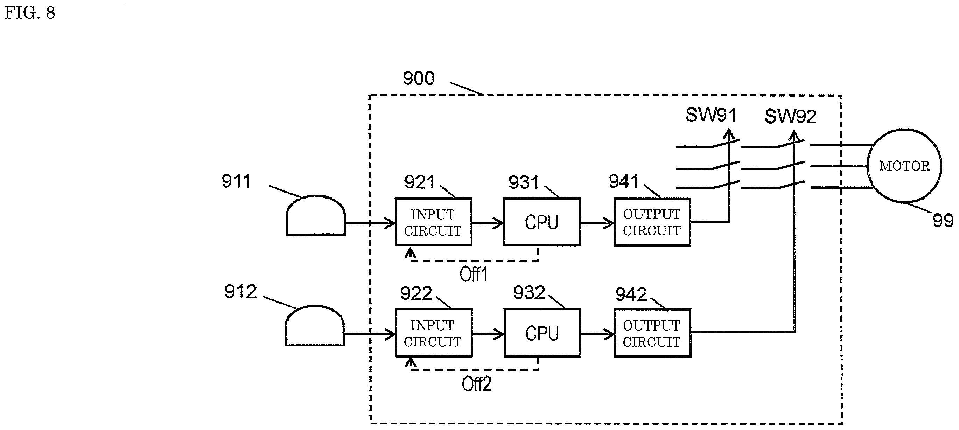

FIG. 8 is a block diagram showing a configuration of such conventional emergency stop circuit unit 900 in a motor control device. In this conventional emergency stop circuit unit 900, when at least one of emergency stop switches 911, 912 is operated to open, an emergency stop command is output from any of CPUs 931, 932 via any of input circuits 921, 922. In response to this emergency stop command, any of switches SW91, SW92 for switching power supply to motor 99 is opened by any of output circuits 941, 942, and a system for operating motor 99 performs an emergency stop. In this way, emergency stop circuit unit 900 duplexes a configuration of an emergency stop circuit by having two input circuits that input the emergency stop command. Also, even in a case where any one line of the emergency stop circuits fails, this duplexing allows motor 99 to be stopped by another line.

Moreover, in this emergency stop circuit unit 900, an opening/closing means for turning off this input function is provided at each of input circuits 921, 922. This opening/closing means is controlled by off signals Off1, Off2 from CPU 931, 932. Accordingly, when the opening/closing means is opened/closed one by one for the duplexed emergency stop circuit, the individual emergency stop circuits can be inspected one by one. With this configuration, inspection of input circuits 921, 922 for the emergency stop can be performed at any time. In other words, in this conventional emergency stop circuit unit 900, an inspection function is provided in the emergency stop circuit, thereby reducing a failure risk of the emergency stop circuit, and further, allowing input circuits 921, 922 for emergency stop signals to be inspected without stopping the system.

However, in the configuration of the conventional emergency stop circuit, though the input circuits for the emergency stop signals can be inspected without stopping the system, it is necessary to stop the input function of the input circuit to be inspected during the inspection to confirm operation of the emergency stop circuit. As a result, in this conventional configuration, there is a problem in that the emergency stop cannot be performed from the input circuit to be inspected and that an effect of the duplexing is lost during the inspection. For example, in FIG. 8, when CPU 931 turns off the input function of input circuit 921 by off signal Off1 and inspects input circuit 921, the emergency stop cannot be performed on motor 99 even when emergency stop switch 911 is operated. Moreover, this conventional system is a system for performing failure detection of only the input circuit, and cannot inspect, for example, output circuits 941, 942 in FIG. 8.

### Citation List

### Patent Literature

PTL 1: Unexamined Japanese Patent Publication No. 2006-268130
WO 2015/145610 A1 discloses a power shut-off device comprising an output terminal connected to a load; a plurality of shut-off circuits connected between a power supply and the output terminal in parallel; and a control device for controlling each of the shut-off circuits. Each of the shut-off circuits has: a switch element connected between the power supply and an intermediate node and on/off-controlled by a shut-off signal output from the control device; and a rectifying element connected so that the direction from the intermediate node to the output terminal is the forward direction thereof. The control device sequentially sets each of the shut-off circuits as a circuit to be diagnosed. The control device sets the shut-off signal output to each of the shut-off circuits so that the switch element of the circuit to be diagnosed is turned off. Further, the control device determines based on the voltage at the intermediate node of the circuit to be diagnosed whether or not an abnormality is present in the circuit to be diagnosed.

EP 2 341 609 A1 discloses a motor control device, which receives at least two emergency stop signals, includes an LSI, a PWM signal transmission circuit, a drive circuit, and an inverter circuit. The LSI generates PWM signals. The PWM signal transmission circuit transmits the PWM signals. The drive circuit generates inverter drive signals. The inverter circuit includes a P-side power switching device and an N-side power switching device. The drive circuit includes a P-side drive circuit for driving the P-side power switching device, and an N-side drive circuit for driving the N-side power switching device. One of the emergency stop signals is inputted to the P-side drive circuit and the PWM signal transmission circuit. The other emergency stop signal is inputted to the N-side drive circuit and the PWM signal transmission circuit. In response to the receipt of an emergency stop signal, the PWM signal transmission circuit stops transmitting the PWM signals, and the drive circuit stops outputting the inverter drive signals.

JP 5,615,470 B1 discloses a power supply control device which comprises a power supply input terminal, an output circuit for outputting power to a load, a plurality of power cut-off circuits connected in parallel between the power supply input terminal and the output circuit, and the plurality of power cut-off circuits. The device further comprises a control circuit for controlling each power cut-off circuit. Each cut-off circuit has a switch element connected in series between the power supply input terminal and the output circuit. The blocking circuit passes the power when receiving the pass enable signal from the control circuit and blocks the passing of the power when the pass enable signal is not received. The switch element is ON-OFF controlled by the control circuit. The control circuit stops the supply of the passage permission signal to the cut-off circuit of the diagnosis target circuit and turns off the switch element of the diagnosis target circuit when setting any of the plurality of power cut-off circuits as the diagnosis target circuit.

### SUMMARY OF THE INVENTION

The invention is defined by the subject-matter of claim 1. The dependent claims relate to preferred embodiments of the invention.

A motor control device of the present disclosure is a motor control device for controlling drive of a motor and having an energization cut-off function that stops energization to the motor by an emergency stop command from the outside. A motor control device of the present disclosure includes: a rotation controller for generating a rotation control signal for controlling rotation operation of the motor; a PWM generator for generating a PWM signal according to the rotation control signal; a drive circuit for outputting a drive pulse signal that on/off controls a switch element according to the PWM signal; an inverter having the switch element and for generating a voltage applied to the motor by PWM control in which the switch element is turned on/off according to the drive pulse signal; a cut-off circuit for cutting off supply of an operating power supply to the drive circuit according to an instruction; a diagnosis pulse generator for generating a diagnosis pulse signal for diagnosing the cut-off circuit by controlling the cut-off of the cut-off circuit; and a cut-off diagnosis unit for detecting existence of the operating power supply to the drive circuit. Also, in the motor control device of the present disclosure, the diagnosis pulse generator gives a cut-off instruction signal based on the diagnosis pulse signal to the cut-off circuit. Accordingly, the cut-off diagnosis unit diagnoses abnormality of the cut-off circuit by detecting the existence of the operating power supply to the drive circuit.

According to this motor control device, abnormality of the cut-off circuit that stops energization to the motor can be diagnosed even in a state in which the motor is driven. Moreover, an effect of duplexing or multiplexing of an emergency stop function can be secured even during the diagnosis.

### BRIEF DESCRIPTION OF DRAWINGS

FIG. 1 is a block diagram showing a configuration of a motor control device in a first exemplary embodiment.
FIG. 2 is a block diagram including a detailed configuration of an energization cut-off unit and configurations of a cut-off diagnosis unit and a diagnosis pulse generator.
FIG. 3 is an operation waveform chart for explaining a method for diagnosing a cut-off part in the first exemplary embodiment.
FIG. 4 is a block diagram showing a configuration of another motor control device in the first exemplary embodiment.
FIG. 5 is a block diagram showing a configuration of a motor control device in a second exemplary embodiment.
FIG. 6 is a block diagram showing a configuration of a motor control device in a third exemplary embodiment.
FIG. 7 is a block diagram showing a configuration of a motor control device in a fourth exemplary embodiment.
FIG. 8 is a block configuration diagram of a cut-off circuit in a motor control device in a conventional example.

### DESCRIPTION OF EMBODIMENTS

Motor control devices in exemplary embodiments are described below with reference to the drawings.

### FIRST EXEMPLARY EMBODIMENT

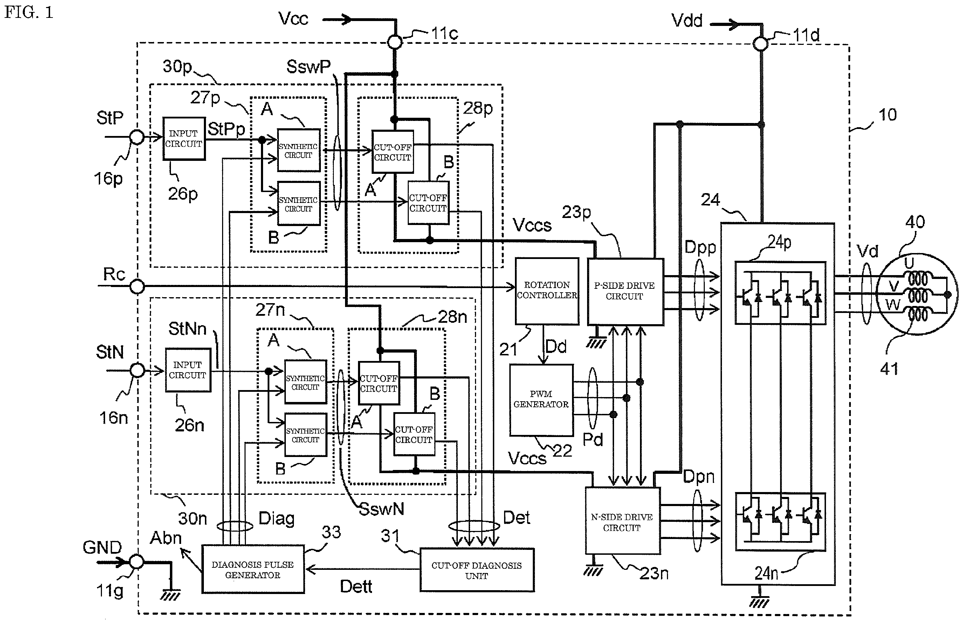

FIG. 1 is a block diagram showing a configuration of motor control device 10 in a first exemplary embodiment.

As shown in FIG. 1, motor 40 is connected to motor control device 10 of the present exemplary embodiment. Motor 40 is an induction motor or a three-phase brushless motor that rotates when three-phase sine waves are applied from motor control device 10. Recently, a three-phase brushless motor in which a magnet is disposed in a rotor has been widely utilized from a viewpoint of efficiency or controllability. In the present exemplary embodiment, as shown in FIG. 1, description is given of a configuration example in which motor control device 10 controls rotation of motor 40 serving as a brushless motor.

Motor 40 includes a rotor that holds a permanent magnet and a stator configured by winding winding 41 around an iron core. The rotor is rotated by energizing and driving winding 41. In the present exemplary embodiment, description is given of an example of a brushless motor in which motor 40 is driven by three phases of a U phase, a V phase, and a W phase having phases different from each other by 120 degrees. In order to perform such three-phase drive, motor 40 has windings 41 for the respective phases of the U phase, the V phase, and the W phase.

Further, motor control device 10 applies drive voltage Vd having a predetermined waveform to these windings 41 for the respective phases, thereby energizing and driving these windings 41. With this configuration, the rotor is rotated according to rotation control by the energization drive from motor control device 10. Further, in order to perform such rotation control, rotation command signal Rc is supplied from, for example, an external controller to motor control device 10. Rotation command signal Rc is, for example, a signal to command rotational speed or torque. Motor control device 10 generates drive voltage Vd having the predetermined waveform such that motor 40 is rotated at the rotational speed or the torque based on this command. With this configuration, motor control device 10 controls motor 40 so as to perform desired rotation operation.

Moreover, voltage for control Vcc on a positive side and voltage for drive Vdd on the positive side are supplied to motor control device 10 together with ground GND on a negative side. Voltage for control Vcc is supplied from a power supply for control (not shown) serving as an operating power supply for operating a low electric power circuit, such as a control circuit. Voltage for drive Vdd is supplied from a power supply for drive (not shown) serving as a power supply having a comparatively large power capacity mainly for energizing and driving winding 41. FIG. 1 shows a configuration example in which voltage for control Vcc is supplied to power supply terminal for control 11c, voltage for drive Vdd is supplied to power supply terminal for drive 11d, and ground GND is connected to ground terminal 11g. It should be noted that, in order to avoid complication, FIG. 1 shows a connection in which voltage for control Vcc and voltage for drive Vdd are supplied only to main units inside motor control device 10. Not surprisingly, the power is appropriately supplied to a necessary circuit.

Also, in the present exemplary embodiment, in order to cut off energization of electric power to motor 40 during emergency, two lines of emergency stop signals serving as emergency stop commands from the outside are supplied to stop signal input terminals in motor control device 10. FIG. 1 shows a configuration example in which one emergency stop signal StP is supplied to stop signal input terminal 16p, and another emergency stop signal StN is supplied to stop signal input terminal 16n.

Next, the configuration of motor control device 10 is described. In order to control the rotor of motor 40 to perform the rotation operation according to rotation command signal Rc, motor control device 10 includes rotation controller 21, PWM generator 22, P-side drive circuit 23p, N-side drive circuit 23n, and inverter 24. Further, in the present exemplary embodiment, in order to cut off supply of electric power to motor 40 and to bring motor 40 to an emergency stop, motor control device 10 includes energization cut-off units 30p, 30n respectively configured with two lines of energization cut-off circuits. Also, in the present exemplary embodiment, motor control device 10 further includes cut-off diagnosis unit 31 and diagnosis pulse generator 33 as a diagnosis function that detects abnormality of the energization cut-off circuit by diagnosing energization cut-off units 30p, 30n.

In motor control device 10 configured in this way, first, rotation controller 21, to which rotation command signal Rc is supplied, generates rotation control signal Dd to control the rotation operation of motor 40 based on this rotation command signal Rc. Rotation control signal Dd is a signal that indicates a drive amount to winding 41, such as a torque amount. Rotation controller 21 supplies such rotation control signal Dd to PWM generator 22.

Next, pulse width modulation (PWM) generator 22 generates, for each of the phases, PWM signal Pd serving as a pulse width modulated signal according to this rotation control signal Dd. In other words, more specifically, PWM generator 22 generates a drive waveform for driving winding 41 for each of the phases, performs pulse width modulation on each of the generated drive waveforms, and outputs the drive waveform as PWM signal Pd. For example, in a case where sine wave drive is performed on winding 41, the drive waveform is a sinusoidal waveform, and amplitude of the drive waveform is determined according to rotation control signal Dd. PWM generator 22 performs the pulse width modulation on each of the drive waveforms generated for each of the phases as a modulated signal. PWM generator 22 supplies PWM signal Pd of a pulse train subjected to the pulse width modulation by the drive waveform to P-side drive circuit 23p and N-side drive circuit 23n.

Next, P-side drive circuit 23p and N-side drive circuit 23n are circuits that on/off control six power-operated switch elements of three-phase inverter 24. P-side drive circuit 23p converts PWM signal Pd from PWM generator 22 into drive pulse signal Dpp for switching and driving the switch elements on a P side (a positive electrode side). Also, P-side drive circuit 23p transmits drive pulse signal Dpp to each of the corresponding switch elements. Further, N-side drive circuit 23n converts PWM signal Pd from PWM generator 22 into drive pulse signal Dpn for switching and driving the switch elements on an N side (a negative electrode side). Also, N-side drive circuit 23n transmits drive pulse signal Dpn to each of the corresponding switch elements.

Further, voltage for drive Vdd and voltage for control Vcc are supplied to P-side drive circuit 23p and N-side drive circuit 23n. Voltage for drive Vdd supplies power to a high voltage primary side circuit, such as inverter 24. Voltage for control Vcc supplies power to a low voltage secondary side circuit, such as the control signal or a connection element with the outside. Also, P-side drive circuit 23p and N-side drive circuit 23n also have a function of insulating voltage for drive Vdd side and voltage for control Vcc side, and an insulation element, such as an optocoupler, is used.

Here, in particular, voltage for control Vcc used in P-side drive circuit 23p is supplied via energization cut-off unit 30p. FIG. 1 shows an example in which voltage for control Vcc is supplied to P-side drive circuit 23p as voltage for control Vccs obtained via energization cut-off unit 30p. Moreover, energization cut-off unit 30p has two lines of cut-off circuits A, B. When voltage for control Vcc is supplied from at least any of the cut-off circuits, P-side drive circuit 23p is operated. Also, P-side drive circuit 23p is stopped when the two lines of cut-off circuits A, B respectively cut off voltage for control Vcc. In this way, a cut-off function of energization cut-off unit 30p has a logical sum configuration such that supply of voltage for control Vcc is cut off only when the whole cut-off circuits are cut off. In other words, when at least one of the whole cut-off circuits is not cut off, voltage for control Vcc is supplied to P-side drive circuit 23p as voltage for control Vccs. This configuration is described below further in detail. Further, energization cut-off unit 30n serving as an N-side circuit also has a similar configuration. Voltage for control Vcc is supplied to N-side drive circuit 23n as voltage for control Vccs via energization cut-off unit 30n having two lines of cut-off circuits A, B.

Next, inverter 24 performs energization to winding 41 for each of the phases based on drive pulse signals Dpp, Dpn to energize and drive winding 41. Inverter 24 includes switch element 24p and switch element 24n for each of the U phase, the V phase, and the W phase. Switch element 24p is connected to the positive electrode side of the power supply for drive, that is, voltage for drive Vdd, and switch element 24n is connected to the negative electrode side, that is, ground GND. Also, in each of the phases, switch element 24p is on/off controlled by drive pulse signal Dpp, and switch element 24n is on/off controlled by drive pulse signal Dpn. Then, drive voltage Vd is further supplied from a drive output to winding 41 via the turned-on switch element from power supply terminal for drive 11d. A drive current flows to winding 41 due to the supply of this drive voltage Vd. Here, PWM signal Pd that generates drive pulse signals Dpp, Dpn is a signal subjected to the pulse width modulation by the drive waveform. Accordingly, each of windings 41 is energized by inverter 24 with the drive current according to the drive waveform.

As described above, motor control device 10 includes rotation controller 21, PWM generator 22, P-side drive circuit 23p, N-side drive circuit 23n, and inverter 24t. Inverter 24 energizes and drives winding 41 with drive voltage Vd. With this configuration, the rotor of motor 40 performs the rotation operation according to rotation command signal Rc.

Next, in motor control device 10 configured as shown in FIG. 1, a configuration of energization cut-off units 30p, 30n for cutting off energization to motor 40 during emergency is described.

First, as mentioned above, in the present exemplary embodiment, the energization cut-off unit is configured with a redundant circuit using a plurality of signals and circuits to raise reliability of an emergency stop function. In other words, FIG. 1 shows two lines of energization cut-off unit 30p on the positive electrode side and energization cut-off unit 30n on the negative electrode side. Also, though details are described below, in the present exemplary embodiment, the emergency stop signals to the plurality of energization cut-off units are configured such that, in a case where motor 40 is stopped, the emergency stop signals are given simultaneously to the respective input circuits. In other words, emergency stop signals StP, StN in FIG. 1 are supplied simultaneously, and respective energization cut-off units 30p, 30n are also operated simultaneously. As a result, even when any one line of the two lines of energization cut-off units 30p, 30n fails, the emergency stop can be performed by the other line, thereby enhancing reliability of the emergency stop function. Further, specifically, when emergency stop is instructed by emergency stop signal StP from the outside, energization cut-off unit 30p is operated so as to cut off supply of voltage for control Vcc to P-side drive circuit 23p. With this configuration, supply of drive pulse signal Dpp to inverter 24 is also cut off, and supply of drive voltage Vd to winding 41 is also cut off, thereby stopping rotation of motor 40. Moreover, when the emergency stop is similarly instructed by emergency stop signal StN from the outside, energization cut-off unit 30n is operated so as to cut off the supply of voltage for control Vcc to N-side drive circuit 23n, thereby stopping the rotation of motor 40. Due to this duplex configuration, when the emergency stop is instructed by at least one signal of emergency stop signal StP and emergency stop signal StN from the outside, the rotation of motor 40 is stopped. Moreover, in the present exemplary embodiment, emergency stop signal StP and emergency stop signal StN are configured to be supplied simultaneously. This enhances reliability of the emergency stop function, as mentioned above.

Next, in order to perform this operation, energization cut-off unit 30p includes input circuit 26p, synthesizing part 27p, and cut-off part 28p, and energization cut-off unit 30n includes input circuit 26n, synthesizing part 27n, and cut-off part 28n.

Input circuit 26p is a circuit that inputs emergency stop signal StP indicating one emergency stop instruction from the outside, and input circuit 26n is a circuit that inputs emergency stop signal StN indicating the other emergency stop instruction from the outside. Input circuit 26p converts emergency stop signal StP from the outside into emergency stop signal StPp indicating the emergency stop instruction inside, and outputs emergency stop signal StPp. Further, input circuit 26n converts emergency stop signal StN from the outside into emergency stop signal StNn indicating the emergency stop instruction inside, and outputs emergency stop signal StNn.

Further, each of synthesizing part 27p and synthesizing part 27n has synthetic circuits A, B. These synthetic circuits A, B of synthesizing part 27p and synthetic circuits A, B of synthesizing part 27n respectively synthesize emergency stop signals StPp, StNn from input circuit 26p and input circuit 26n and diagnosis pulse signal Diag from diagnosis pulse generator 33. Then, synthetic circuits A, B of synthesizing part 27p and synthetic circuits A, B of synthesizing part 27n respectively output stop signals SswP, SswN to cut-off part 28p and cut-off part 28n.

Further, each of cut-off part 28p and cut-off part 28n has cut-off circuits A, B. These cut-off circuits A, B of cut-off part 28p and cut-off circuits A, B of cut-off part 28n are operated such that supply of voltage for control Vcc is cut off according to stop signals SswP, SswN that serve as cut-off instruction signals output from synthetic circuits A, B corresponding to the cut-off circuits. In other words, each of cut-off part 28p and cut-off part 28n includes cut-off circuit A and cut-off circuit B connected in parallel, and voltage for control Vcc is connected to each of cut-off circuit A and cut-off circuit B. As a result, in cut-off part 28p, output of voltage for control Vcc is stopped by making cut-off circuit A and cut-off circuit B in cut-off states by stop signal SswP. Also, in cut-off part 28n, output of voltage for control Vcc is stopped by making cut-off circuit A and cut-off circuit B in cut-off states by stop signal SswN. Voltage for control Vccs obtained via such cut-off part 28p and cut-off part 28n is supplied to P-side drive circuit 23p and N-side drive circuit 23n.

Here, circuit configurations of synthetic circuits A, B are determined by logic of input emergency stop signals StPp, StNn, and diagnosis pulse signal Diag. For example, in a case where levels of emergency stop signals StPp, StNn are "H" and indicate emergency stop instructions and a level of diagnosis pulse signal Diag is "H" and indicates diagnosis, a logical sum is performed on synthetic circuits A, B, and cut-off circuits A, B are cut off at level "H". Further, as another example, in a case where the levels of emergency stop signals StPp, StNn are "L" and indicate emergency stop instructions and a level of diagnosis pulse signal Diag is "L" and indicates diagnosis, a logical product is performed on synthetic circuits A, B, and cut-off circuits A, B are cut off at level "L". It should be noted that, in a case where the levels of emergency stop signals StPp, StNn are "H" ("H" is "1" in a truth value), the level of diagnosis pulse signal Diag is also "H", and stop of cut-off circuits A, B is indicated, synthetic circuits A, B are configured by the logical sum, as mentioned above. By configuring in this way, regardless of the level of diagnosis pulse signal Diag, cut-off circuits A, B can be cut off by emergency stop signals StPp, StNn.

As described above, since motor control device 10 includes energization cut-off unit 30p and energization cut-off unit 30n, supply of voltage for control Vcc to the drive circuit is cut off by at least one emergency stop instruction, and motor 40 can be immediately stopped during emergency.

Next, in motor control device 10 configured as shown in FIG. 1, configurations of cut-off diagnosis unit 31 and diagnosis pulse generator 33 for diagnosing cut-off parts 28p, 28n of energization cut-off units 30p, 30n are described.

In order to confirm correct operation of cut-off circuits A, B, diagnosis pulse generator 33 periodically generates diagnosis pulse signal Diag, and individually outputs diagnosis pulse signal Diag to each of synthetic circuits A, B, as described below. Diagnosis pulse signal Diag is a signal for diagnosing cut-off circuits A, B by controlling cut-off of cut-off circuits A, B. Diagnosis pulse generator 33 outputs a total of four diagnosis pulse signals Diag to synthesizing part 27p and synthesizing part 27n. Timing of pulse output of diagnosis pulse signals Diag is different between synthetic circuit A and synthetic circuit B. Regarding a period of generating a pulse for diagnosis of diagnosis pulse signal Diag, the diagnosis is performed within a mean time between failures (MTBF) of cut-off circuits A, B.

Cut-off diagnosis unit 31 is provided to detect existence of supply of the operating power supply to P-side drive circuit 23p and N-side drive circuit 23n. In other words, cut-off diagnosis unit 31 detects existence of supply of voltage for control Vccs on output sides of cut-off circuits A, B and outputs the result to diagnosis pulse generator 33. In other words, a total of four cut-off information signals Det indicating the existence of the supply of voltage for control Vccs in cut-off circuits A, B are supplied to cut-off diagnosis unit 31 from cut-off part 28P and cut-off part 28n. Then, cut-off diagnosis unit 31 generates diagnosis information signal Dett indicating information about the supply of voltage for control Vccs based on cut-off information signal Det, and outputs diagnosis information signal Dett to diagnosis pulse generator 33. Diagnosis pulse generator 33 for diagnosing abnormality of cut-off circuits A, B determines abnormality of cut-off circuits A, B by diagnosis information signal Dett from cut-off diagnosis unit 31. Then, diagnosis pulse generator 33 outputs abnormality determination signal Abn indicating a result of this abnormality determination. Further, cut-off diagnosis unit 31 directly detects abnormality of cut-off circuits A, B based on cut-off information signal Det.

Next, description is given of a detailed configuration of energization cut-off unit 30p and energization cut-off unit 30n configured as described above.

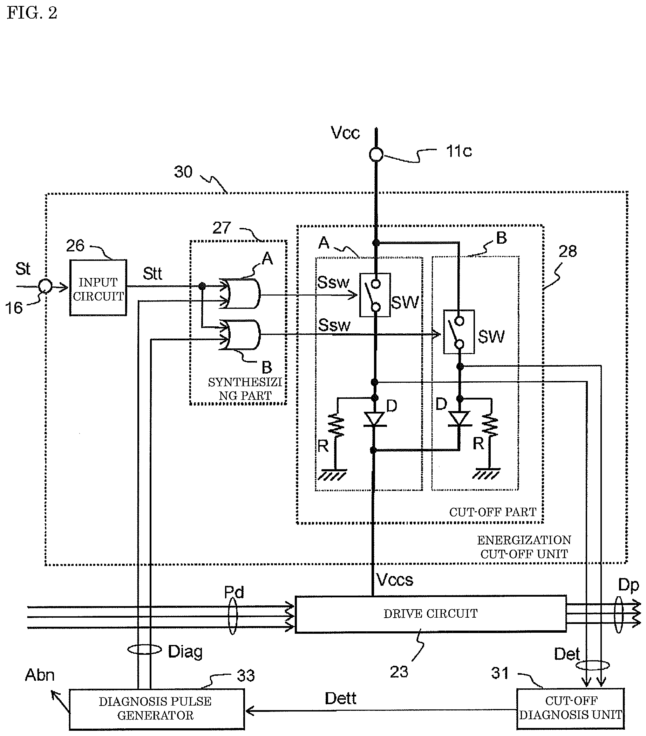

FIG. 2 is a block diagram including the detailed configuration of energization cut-off unit 30p and energization cut-off unit 30n and the configurations of cut-off diagnosis unit 31 and diagnosis pulse generator 33. FIG. 2 shows only one of energization cut-off unit 30p and energization cut-off unit 30n. In FIG. 2, energization cut-off unit 30 corresponds to any of energization cut-off units 30p, 30n, drive circuit 23 corresponds to any of P-side drive circuit 23p and N-side drive circuit 23n, input circuit 26 corresponds to any of input circuits 26p, 26n, synthesizing part 27 corresponds to any of synthesizing parts 27p, 27n, and cut-off part 28 corresponds to any of cut-off parts 28p, 28n. Moreover, emergency stop signal Stt corresponds to any of emergency stop signal StPp and emergency stop signal StNn. Further, FIG. 2 shows a configuration example in which emergency stop is indicated when levels of emergency stop signal St from the outside and of emergency stop signal Stt output from input circuit 26 are "H", and diagnosis of cut-off part 28 is indicated when a level of diagnosis pulse signal Diag is "H".

First, in order to correspond to these signals, synthetic circuits A, B of synthesizing part 27 are each configured with an OR circuit that performs logical operation of logical sum, as shown in FIG. 2. Further, emergency stop signal Stt from input circuit 26 is supplied to one input of the OR circuit of each of synthetic circuits A, B, and diagnosis pulse signal Diag from diagnosis pulse generator 33 is supplied to another input of each of synthetic circuits A, B.

Next, each of cut-off circuits A, B configuring cut-off part 28 is configured with switch SW, diode D, and resistor R. One terminal of switch SW is connected to voltage for control Vcc, and another terminal of switch SW is connected to an anode terminal of diode D. Further, stop signal Ssw from synthetic circuit A, B is supplied to a switching terminal of switch SW. FIG. 2 shows an example of a case where switch SW is turned off when a level of stop signal Ssw is "H". The case corresponds to the indication of emergency stop when the input of synthetic circuit A, B serving as the OR circuit is "H". Moreover, one end of resistor R is connected to the anode terminal of diode D, and another end of resistor R is connected to ground. Also, cut-off information signal Det indicating a detection result of the existence of the supply of voltage for control Vcc is output from the other terminal of switch SW.

Further, a cathode terminal of diode D included in cut-off circuit A and a cathode terminal of diode D included in cut-off circuit B are connected in cut-off part 28. A connecting part between these two cathode terminals is supplied to drive circuit 23 as voltage for control Vccs via cut-off part 28.

In energization cut-off unit 30 configured in this way, first, each of synthetic circuits A, B of synthesizing part 27 is configured with the OR circuit, as mentioned above. As a result, when both the levels of emergency stop signal Stt and diagnosis pulse signal Diag are "L", that is, in a case of a normal state, stop signal Ssw having level "L" is output from each of synthetic circuits A, B. Hence, in this case, switch SW of each of cut-off circuits A, B is turned on, and voltage for control Vccs is supplied to drive circuit 23 via cut-off part 28.

In contrast with this normal state, in a case where the emergency stop in which the level of emergency stop signal St is "H" is instructed from the outside, emergency stop signal Stt is supplied to each input of synthetic circuits A, B. Accordingly, stop signal Ssw having level "H" is output from each of synthetic circuits A, B. Hence, in a case where the emergency stop is instructed in this way, switch SW of each of cut-off circuits A, B is turned off, and the supply of voltage for control Vcc is cut off. Also, voltage for control Vccs is not supplied to drive circuit 23 in this state, and motor 40 is stopped as mentioned above.

Moreover, in a case where only the level of one diagnosis pulse signal Diag from diagnosis pulse generator 33 is "H", only one switch SW is turned off. At this time, other switch SW is turned on, and voltage for control Vccs is supplied to drive circuit 23 via other switch SW. Accordingly, motor 40 is operated as with the normal state. Also, in the present exemplary embodiment, since diode D is provided in each of synthetic circuits A, B, cut-off information signal Det at a connecting place between switch SW and the anode terminal of diode D has a level according to a state of switch SW. For example, in a case where switch SW of synthetic circuit B is turned on and switch SW of synthetic circuit A is turned off, the level of cut-off information signal Det is as follows. In other words, since cut-off information signal Det of cut-off circuit B is electrically connected to voltage for control Vcc via switch SW in the on state, the level of cut-off information signal Det of synthetic circuit B is "H". Further, since switch SW is turned off, ground GND is electrically connected to the anode terminal of diode D via resistor R, and the level of cut-off information signal Det of synthetic circuit A is "L". Particularly, in the present exemplary embodiment, since diode D is provided, diode D becomes reverse bias from cut-off information signal Det of synthetic circuit B (the level is "H") to cut-off information signal Det of synthetic circuit A (the level is "L"). As a result, cut-off information signals Det between synthetic circuits A, B do not interfere with each other, a level on the other terminal side of switch SW of each of synthetic circuits A, B can be detected, and an on/off state of switch SW can also be detected based on this detected level.

Since such energization cut-off unit 30 is included in the present exemplary embodiment, an opening/closing state of switch SW can be confirmed by the level of cut-off information signal Det of one switch SW while operating motor 40. Moreover, since the opening/closing state of switch SW can be confirmed, it is possible to diagnose whether cut-off circuits A, B of cut-off part 28 are operated normally according to the emergency stop instruction.

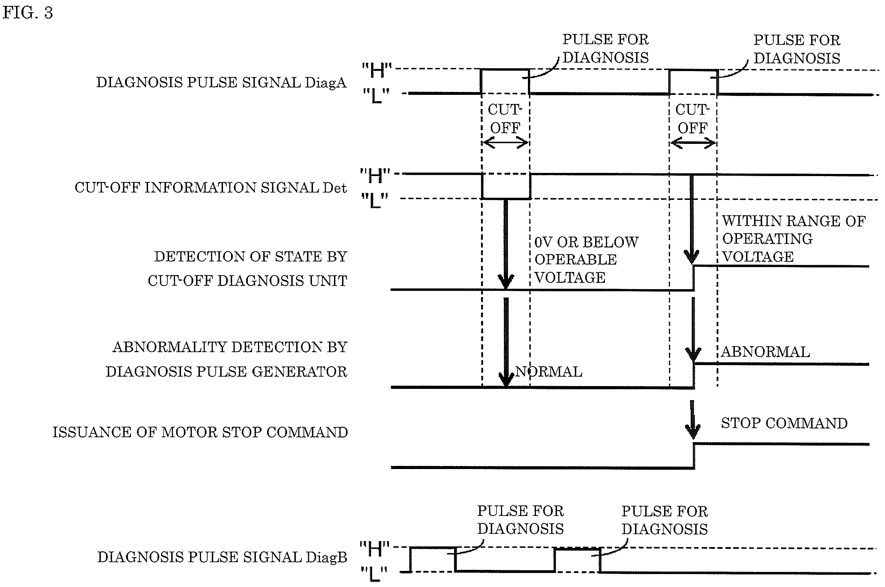

Next, a method for diagnosing cut-off part 28 is described with reference to FIG. 3. FIG. 3 is an operation waveform chart for explaining the method for diagnosing cut-off part 28.

Diagnosis pulse generator 33 periodically outputs diagnosis pulse signal Diag. As shown by diagnosis pulse signal DiagA and diagnosis pulse signal DiagB in FIG. 3, this diagnosis pulse signal Diag is configured such that pulses for diagnosis are not simultaneously output to synthetic circuit A and synthetic circuit B. As an example, in a case where diagnosis pulse generator 33 outputs diagnosis pulse signal Diag to synthetic circuit A, cut-off information signal Det output from cut-off circuit A is notified to cut-off diagnosis unit 31. Here, cut-off information signal Det indicates the level of the other terminal of switch SW when switch SW of cut-off circuit A is turned off. In other words, in this case, if the level of cut-off information signal Det is "L", this cut-off circuit A is operated normally. Hence, as shown by detection of a state by the cut-off diagnosis unit in FIG. 3, cut-off diagnosis unit 31 detects that voltage of cut-off information signal Det is 0 V or falls below operable voltage of drive circuit 23, thereby determining that the level is "L" serving as the normal level. Then, cut-off diagnosis unit 31 outputs a diagnosis result by this determination to diagnosis pulse generator 33 as diagnosis information signal Dett. Diagnosis pulse generator 33 confirms from this result that the cut-off circuit is operated normally, and then performs similar operation on synthetic circuit B.

Further, in this series of operation, for example, diagnosis pulse generator 33 outputs diagnosis pulse signal Diag to synthetic circuit A, and the voltage of cut-off information signal Det from cut-off circuit A detected by cut-off diagnosis unit 31 is within the operable voltage of drive circuit 23, as shown in FIG. 3. In this case, cut-off diagnosis unit 31 determines that the level of cut-off information signal Det is "H" serving as an abnormal level. Cut-off diagnosis unit 31 outputs diagnosis information signal Dett serving as a diagnosis result indicating abnormality to diagnosis pulse generator 33. Then, diagnosis pulse generator 33 determines that cut-off circuit A is abnormal. Diagnosis pulse generator 33 outputs, for example, abnormality determination signal Abn to synthesizing part 27, and stops energization to motor 40.

Further, in a case where, for a synthetic circuit to which the pulse for diagnosis of diagnosis pulse signal Diag is not output, the level of cut-off information signal Det output from a corresponding cut-off circuit is "L", diagnosis pulse generator 33 may also determine that the cut-off circuit is abnormal.

In a case where diagnosis pulse generator 33 determines that the cut-off circuit is abnormal, the PWM signal output to drive circuit 23 is stopped. Further, diagnosis pulse generator 33 outputs a stop signal to each of the synthetic circuits such that each of the cut-off circuits stops supply of voltage for control Vccs to the drive circuit.

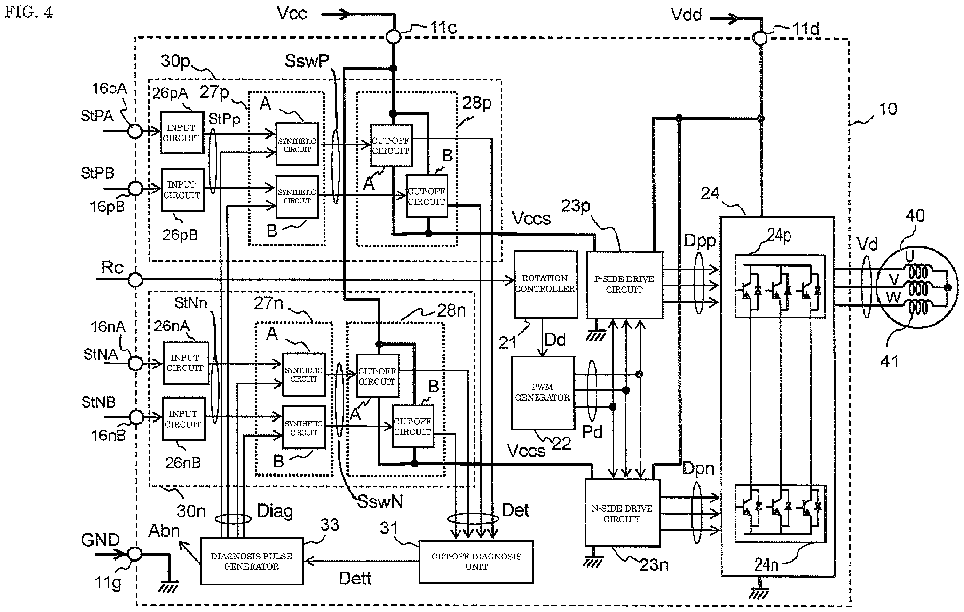

Further, in FIG. 1, description is given of a configuration example in which emergency stop signal StPp from input circuit 26p is branched into each of synthetic circuits A, B of synthesizing part 27p, and emergency stop signal StNn from input circuit 26n is branched into each of synthetic circuits A, B of synthesizing part 27n. Instead of this configuration, as shown in FIG. 4, the positive electrode side may be separated into input circuit 26pA and input circuit 26pB, and the negative electrode side may be separated into input circuit 26nA and input circuit 26nB. In other words, in FIG. 4, emergency stop signal StPA input to stop signal input terminal 16pA is supplied to input circuit 26pA. Emergency stop signal StPB input to stop signal input terminal 16pB is supplied to input circuit 26pB. Emergency stop signal StNA input to stop signal input terminal 16nA is supplied to input circuit 26nA. Also, emergency stop signal StNB input to stop signal input terminal 16nB is supplied to input circuit 26nB.

By having the above-described configuration, it is possible to diagnose abnormality of a cut-off circuit that stops energization to motor 40 even in a state in which motor 40 is driven. Moreover, since both energization cut-off unit 30p and energization cut-off unit 30n are operable even during the diagnosis, an effect of duplexing of an emergency stop function can be secured.

### SECOND EXEMPLARY EMBODIMENT

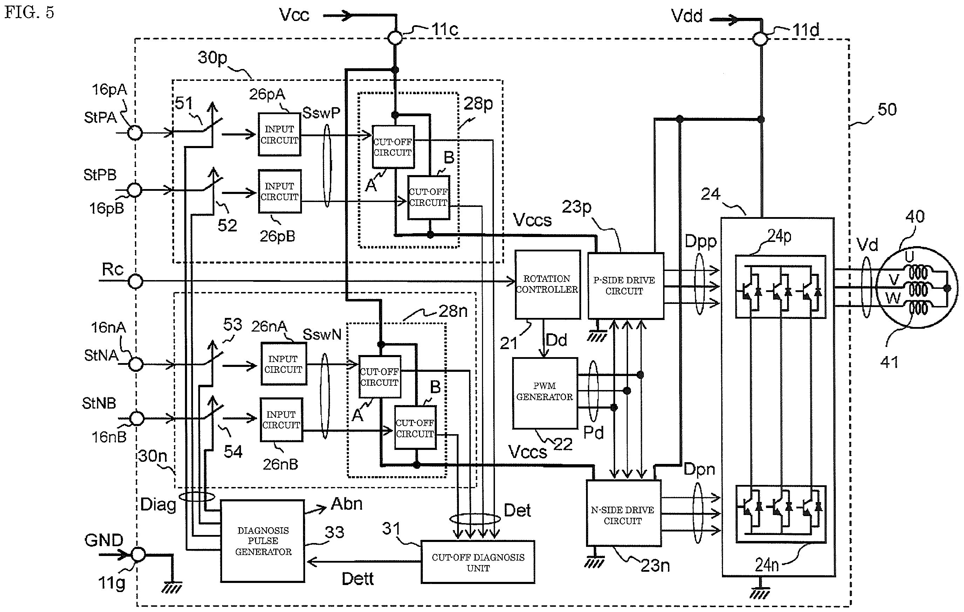

FIG. 5 is a block diagram showing a configuration of motor control device 50 in a second exemplary embodiment. The present exemplary embodiment is described with reference to FIG. 5. What is different from the configuration in the first exemplary embodiment shown in FIG. 4 is a configuration in which cut-off circuits A, B are cut off by diagnosis pulse signal Diag. The configuration in the present exemplary embodiment is described below.

In the present exemplary embodiment, as shown in FIG. 5, switches 51, 52, 53, and 54 that respectively cut off emergency stop signals StPA, StPB, StNA, and StNB from the outside are provided, and are on/off controlled by diagnosis pulse signal Diag from diagnosis pulse generator 33. Further, signals SswP, SswN from input circuits 26pA, 26pB, 26nA, and 26nB are directly connected to cut-off circuits A, B of cut-off parts 28p, 28n, respectively.

Operation of diagnosis pulse generator 33 is similar to the operation in the first exemplary embodiment. For example, diagnosis pulse generator 33 operates as follows. First, diagnosis pulse signal Diag is output so as to cut off emergency stop signal StPA connected to input circuit 26pA, thereby cutting off voltage for control Vcc to cut-off circuit A. Cut-off diagnosis unit 31 determines existence of abnormality of cut-off circuit A by detecting a level of cut-off information signal Det. Next, the same diagnosis is performed on input circuit 26pB. Further, input circuit 26nA and input circuit 26nB are diagnosed in the same manner as mentioned above. In a case where abnormality is detected, energization to motor 40 is stopped.

In a case where diagnosis pulse generator 33 determines that the cut-off circuit is abnormal, a PWM signal output to drive circuit 23 is stopped. Further, in a similar case, diagnosis pulse generator 33 may output a stop signal to each synthetic circuit such that each of the cut-off circuits stops supply of voltage for control Vccs to the drive circuit.

By having the above-described configuration, it is possible to diagnose the cut-off circuits including the input circuits in addition to diagnosing abnormality of the cut-off circuit that stops energization to motor 40 even in a state where motor 40 is driven.

### THIRD EXEMPLARY EMBODIMENT

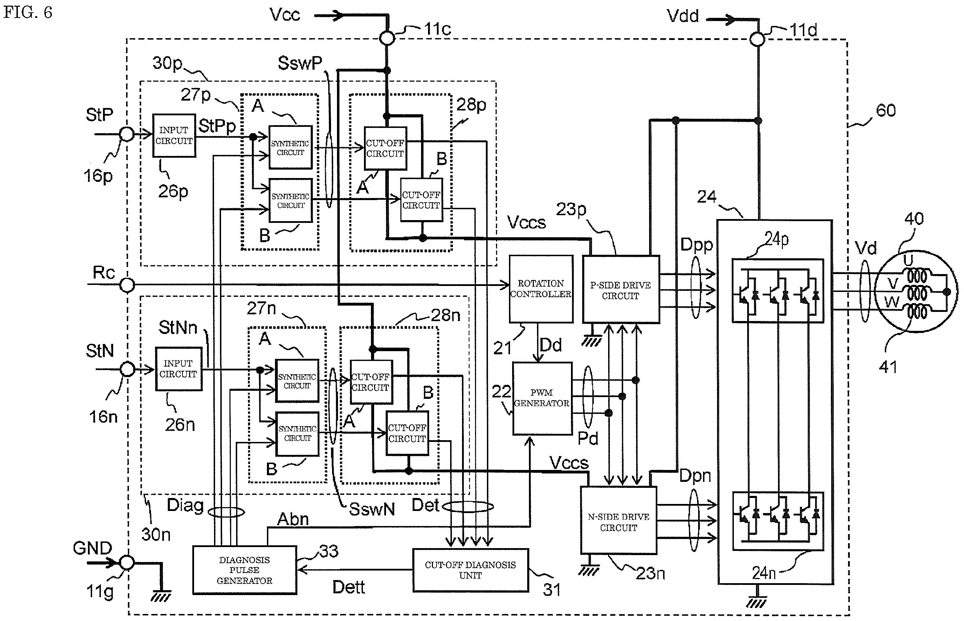

FIG. 6 is a block diagram showing a configuration of motor control device 60 in a third exemplary embodiment. The present exemplary embodiment is described with reference to FIG. 6. What is different from the configuration in the first exemplary embodiment shown in FIG. 1 is a configuration in which motor 40 is stopped when an emergency stop signal is input and in a case where cut-off diagnosis unit 31 determines that a cut-off circuit is abnormal. The configuration in the present exemplary embodiment is described below.

In the present exemplary embodiment, in a case where cut-off diagnosis unit 31 diagnoses that the cut-off circuit is abnormal, diagnosis pulse generator 33 outputs a cut-off signal to each synthetic circuit, and outputs abnormality determination signal Abn to PWM generator 22. Based on abnormality determination indicated by abnormality determination signal Abn, PWM generator 22 stops output of PWM signal Pd and stops energization to motor 40.

By having the above-described configuration, the output of PWM signal Pd is stopped during abnormality in addition to the diagnosis of the abnormality of the cut-off circuit that stops energization to motor 40 even in a state where motor 40 is driven. Accordingly, it is possible to configure a safer diagnosis device for the cut-off circuits.

### FOURTH EXEMPLARY EMBODIMENT

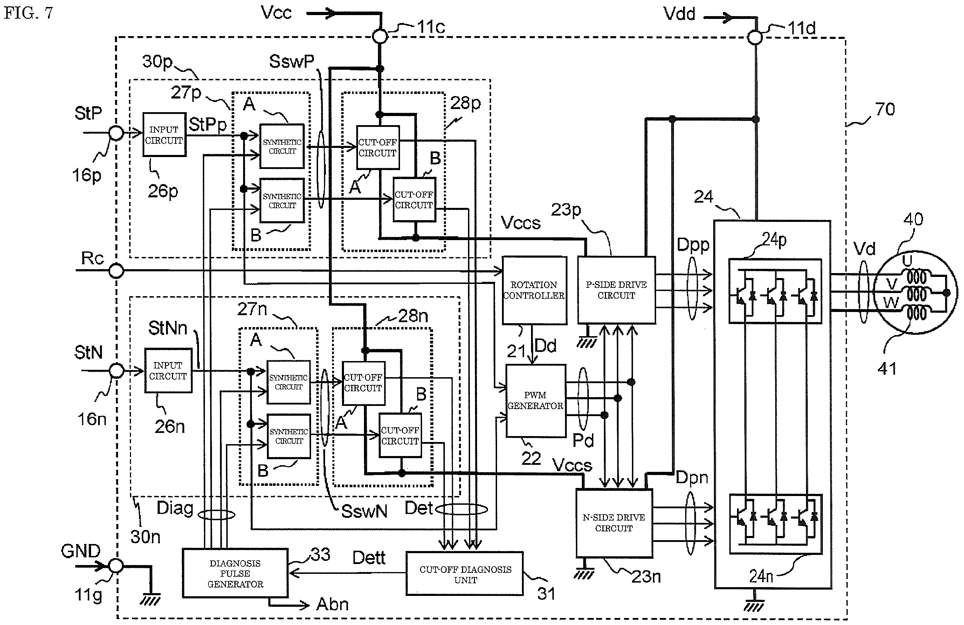

FIG. 7 is a block diagram showing a configuration of motor control device 70 in a fourth exemplary embodiment. The present exemplary embodiment is described with reference to FIG. 7. What is different from the configuration in the third exemplary embodiment shown in FIG. 6 is a configuration in which motor 40 is stopped in a case where an emergency stop signal is input. The configuration in the present exemplary embodiment is described below.

Emergency stop signals StP, StN from the outside are input to synthesizing parts 27p, 27n from input circuit 26p and input circuit 26n, and are also input to PWM generator 22. In the present exemplary embodiment, by having this configuration, PWM generator 22 stops output of PWM signal Pd and stops energization to motor 40 when emergency stop signals StP, StN are input.

By having the above-described configuration, PWM generator 22 immediately stops the output of PWM signal Pd based on the emergency stop signals from input circuit 26p and input circuit 26n, in addition to diagnosis of abnormality of a cut-off circuit that stops energization to motor 40 even in a state where motor 40 is driven. Accordingly, a safe diagnosis device for the cut-off circuit can be configured without considering a failure in circuits after input circuit 26p and input circuit 26n.

Further, abnormality determination signal Abn from diagnosis pulse generator 33 may be output to PWM generator 22, and PWM generator 22 may stop output of PWM signal Pd when abnormality is diagnosed.

### INDUSTRIAL APPLICABILITY

Diagnosis that detects a failure of a cut-off circuit for cutting off energization to a motor by an emergency stop command can be performed without stopping driving of the motor. Accordingly, the present invention is effective for a motor control device that is continuously operated without being stopped after a power supply is once turned on.

### REFERENCE MARKS IN THE DRAWINGS

10, 50, 60, 70: motor control device
11c: power supply terminal for control
11d: power supply terminal for drive
11g: ground terminal
16, 16p, 16pA, 16pB, 16n, 16nA, 16nB: stop signal input terminal
21: rotation controller
22: PWM generator
23: drive circuit
23n: N-side drive circuit
23p: P-side drive circuit
24: inverter
24n, 24p: switch element
26, 26n, 26p, 26nA, 26nB, 26pA, 26pB, 921, 922: input circuit
27, 27n, 27p: synthesizing part
28, 28n, 28p: cut-off part
30, 30n, 30p: energization cut-off unit
31: cut-off diagnosis unit
33: diagnosis pulse generator
40, 99: motor
41: winding
51, 52, 53, 54: switch
900: emergency stop circuit unit
911: emergency stop switch
941: output circuit

## Claims

1. A motor control device (10, 50, 60, 70) configured to control drive of a motor (40) and having an energization cut-off function that stops energization to the motor (40) by an emergency stop command from outside,
the motor control device (10, 50, 60, 70) comprising:
a rotation controller (21) configured to generate a rotation control signal for controlling rotation operation of the motor (40);
a pulse width modulation, PWM, generator (22) configured to generate a PWM signal according to the rotation control signal;
drive circuits (23p, 23n) configured to output a drive pulse signal that on/off controls switch elements (24p, 24n) according to the PWM signal;
an inverter (24) having the switch elements (24p, 24n) and configured to generate a voltage applied to the motor (40) by PWM control, the switch elements (24p, 24n) being turned on/off according to the drive pulse signal in the PWM control;
two energization cutoff units (30p, 30n) respectively configured with two lines of cut-off circuits (28p, 28n) configured to cut off supply of an operating power supply to the drive circuits (23p, 23n) according to an instruction,
wherein
the switch elements (24p, 24n) of the inverter (24) have a P-side switch element (24p) and an N-side switch element (24n),
the drive circuits (23p, 23n) include a P-side drive circuit (23p) configured to on/off control the P-side switch element (24p) and an N-side drive circuit (23n) configured to on/off control the N-side switch element (24n), and
**characterized by**
a diagnosis pulse generator (33) configured to generate diagnosis pulse signals (Diag) for diagnosing the cut-off circuits (28p, 28n) by controlling the cut-off of the cut-off circuits (28p, 28n); and
a cut-off diagnosis unit (31) configured to detect existence of the supply of the operating power supply to the drive circuits (23p, 23n),
the cut-off diagnosis unit (31) is configured to diagnose as the diagnosis pulse generator (33) gives a cut-off instruction signal based on the diagnosis pulse signal (Diag) to the cut-off circuits (28p, 28n), abnormality of the cut-off circuits (28p, 28n) by detecting the existence of the operating power supply to the drive circuits (23p, 23n),
wherein
the cut-off circuits (28p, 28n) include first to fourth cut-off circuits (28pA, 28pB, 28nA, 28nB),
the P-side drive circuit (23p) is supplied with the operating power supply from the first cut-off circuit (28pA) and the second cut-off circuit (28pB),
the N-side drive circuit (23n) is supplied with the operating power supply from the third cut-off circuit (28nA) and the fourth cut-off circuit (28nB),
the diagnosis pulse generator (33) is configured to periodically generate first to fourth diagnosis pulse signals (Diag) and is configured to give the first and second diagnosis pulse signals (Diag) with a time difference to the respective first and second cut-off circuits (28pA, 28pB) configured to supply the operating power supply to the P-side drive circuit (23p), and gives the diagnosis pulse signals with a time difference to the respective third and fourth cut-off circuits (28nA, 28nB) configured to supply the operating power supply to the N-side drive circuit (23n), and
the cut-off diagnosis unit (31) is configured to diagnose abnormality of the cut-off circuits (28pA, 28pB, 28nA, 28nB) by detecting existence of the operating power supply to be supplied from each of the cut-off circuits (28pA, 28pB, 28nA, 28nB),
the first to fourth cut-off circuits (28pA, 28pB, 28nA, 28nB) respectively include first to fourth switches (SW) that are configured to supply a voltage for control (Vccs) to the drive circuits (23p, 23n) in the on state and output a cut-off information signal (Det) indicating result of detected existence of supply of the voltage for control (Vccs) to the cut-off diagnosis unit (31) in the off state,
the cut-off diagnosis unit (31) is configured to diagnose abnormality of each of the cut-off circuits based on the cut-off information signal (Det) obtained from the first to fourth switches (SW), and
the motor control device (10, 50, 60, 70) comprises synthesizing circuits (27pA, 27pB, 27nA, 27nB) each of which is configured to logically synthesize the diagnosis pulse signal (Diag) from the diagnosis pulse generator (33) with the emergency stop command and to output stop signals (SswP, SswN) to the respective first to fourth cut-off circuits (28pA, 28pB, 28nA, 28nB),
wherein the cut-off circuits (28pA, 28pB, 28nA, 28nB) are configured to stop supply of the operating power supply to the drive circuits (23p, 23n) when the emergency stop command is given,
wherein a period of generating the diagnosis pulse signals (Diag) is performed within a mean time between failures, MTBF, of the first to fourth cut-off circuits (28pA, 28pB, 28nA, 28nB).

2. The motor control device according to claim 1, further comprising:
switches (51, 52, 53, 54) each of which is configured to be on/off controlled by the diagnosis pulse signal from the diagnosis pulse generator (33) and cut off the emergency stop command,
wherein the switches (51, 52, 53, 54) are configured to cut off the emergency stop command in accordance with the diagnosis pulse signal.

3. The motor control device according to claim 1, wherein
the diagnosis pulse generator (33) is configured to output, in a case where the cut off diagnosis unit (31) diagnoses that any of cut off circuits (28pA, 28pB, 28nA, 28nB) is abnormal, a cut off signal to the first to fourth synthetic circuits (27pA, 27pB, 27nA, 27nB) and to output an abnormality determination signal that stops the PWM signal for driving the inverter (24).

4. The motor control device according to claim 1, wherein
the emergency stop command is supplied to the PWM generator (22), and
in a case where the emergency stop command is given, the PWM generator (22) stops the PWM signal for driving the inverter (24).

5. The motor control device according to claims 1 or 4, wherein
the four cut-off circuits (28pA, 28pB, 28nA, 28nB) are configured to cut off a supply of voltage according to the stop signals (SswP, SswN).

## Patentansprüche

1. Motorsteuervorrichtung (10, 50, 60, 70), die so konfiguriert ist, dass sie den Antrieb eines Motors (40) steuert, und die eine Antriebsabschaltfunktion hat, die den Antrieb des Motors (40) durch einen Not-Aus-Befehl von außen stoppt,
wobei die Motorsteuerungsvorrichtung (10, 50, 60, 70) umfasst:
eine Rotationssteuerung (21), die so konfiguriert ist, dass sie ein Rotationssteuersignal zur Steuerung des Rotationsbetriebs des Motors (40) erzeugt;
einen Pulsweitenmodulationsgenerator (PWM) (22), der so konfiguriert ist, dass er ein PWM-Signal entsprechend dem Rotationssteuersignal erzeugt;
Antriebsschaltungen (23p, 23n), die so konfiguriert sind, dass sie ein Ansteuerungsimpulssignal ausgeben, das die Schaltelemente (24p, 24n) entsprechend dem PWM-Signal ein-/aussteuert;
einen Wechselrichter (24), der die Schaltelemente (24p, 24n) aufweist und so konfiguriert ist, dass er eine an den Motor (40) angelegte Spannung durch PWM-Steuerung erzeugt, wobei die Schaltelemente (24p, 24n) entsprechend dem Ansteuerimpulssignal in der PWM-Steuerung ein- und ausgeschaltet werden;
zwei Stromunterbrechungseinheiten (30p, 30n), die jeweils mit zwei Reihen von Unterbrechungsschaltungen (28p, 28n) konfiguriert sind, die so konfiguriert sind, dass sie die Zufuhr einer Betriebsstromversorgung zu den Antriebsschaltungen (23p, 23n) gemäß einem Befehl unterbrechen,
wobei
die Schaltelemente (24p, 24n) des Wechselrichters (24) ein P-seitiges Schaltelement (24p) und ein N-seitiges Schaltelement (24n) aufweisen,
die Antriebsschaltungen (23p, 23n) eine P-Seiten-Antriebsschaltung (23p), die so konfiguriert ist, dass sie das P-Seiten-Schaltelement (24p) ein-/ausschaltet, und eine N-Seiten-Antriebsschaltung (23n), die so konfiguriert ist, dass sie das N-Seiten-Schaltelement (24n) ein-/ausschaltet, umfassen, und
**gekennzeichnet durch**
einen Diagnoseimpulsgenerator (33), der so konfiguriert ist, dass er Diagnoseimpulssignale (Diag) zum Diagnostizieren der Abschaltschaltungen (28p, 28n) durch Steuern der Abschaltung der Abschaltschaltungen (28p, 28n) erzeugt; und
eine Abschaltdiagnoseeinheit (31), die so konfiguriert ist, dass sie das Vorhandensein der Versorgung der Betriebsstromversorgung für die Antriebsschaltungen (23p, 23n) erkennt, und
die Abschaltdiagnoseeinheit (31) so konfiguriert ist, dass sie, wenn der Diagnoseimpulsgenerator (33) ein Abschaltbefehlssignal auf der Grundlage des Diagnoseimpulssignals (Diag) an die Abschaltschaltungen (28p, 28n) abgibt, eine Anomalie der Abschaltschaltungen (28p, 28n) diagnostiziert, indem sie das Vorhandensein der Betriebsstromversorgung der Antriebsschaltungen (23p, 23n) erfasst,
wobei
die Abschaltkreise (28p, 28n) erste bis vierte Abschaltschaltungen (28pA, 28pB, 28nA, 28nB) umfassen,
der P-seitige Antriebskreis (23p) von der ersten Abschaltschaltung (28pA) und der zweiten Abschaltschaltung (28pB) mit der Betriebsstromversorgung versorgt wird,
der N-seitige Antriebskreis (23n) mit der Betriebsstromversorgung aus dem dritten Abschaltkreis (28nA) und dem vierten Abschaltkreis (28nB) versorgt wird,
der Diagnoseimpulsgenerator (33) so konfiguriert ist, dass er periodisch erste bis vierte Diagnoseimpulssignale (Diag) erzeugt, und so konfiguriert ist, dass er die ersten und zweiten Diagnoseimpulssignale (Diag) mit einer Zeitdifferenz an die jeweiligen ersten und zweiten Abschaltschaltungen (28pA, 28pB) abgibt, die so konfiguriert sind, dass sie die Betriebsstromversorgung an die P-seitige Antriebsschaltung (23p) liefern, und die Diagnoseimpulssignale mit einer Zeitdifferenz an die jeweiligen dritten und vierten Abschaltschaltungen (28nA, 28nB) abgibt, die so konfiguriert sind, dass sie die Betriebsstromversorgung an die N-seitige Antriebsschaltung (23n) liefern, und
die Abschaltdiagnoseeinheit (31) so konfiguriert ist, dass sie eine Anomalie der Abschaltschaltungen (28pA, 28pB, 28nA, 28nB) diagnostiziert, indem sie das Vorhandensein der Betriebsstromversorgung, die von jeder der Abschaltschaltungen (28pA, 28pB, 28nA, 28nB) zu liefern ist, erfasst,
die ersten bis vierten Abschaltschaltungen (28pA, 28pB, 28nA, 28nB) jeweils erste bis vierte Schalter (SW) enthalten, die so konfiguriert sind, dass sie eine Steuerspannung (Vccs) an die Anstriebsschaltungen (23p, 23n) im eingeschalteten Zustand liefern und ein Abschaltinformationssignal (Det) ausgeben, das das Ergebnis der detektierten Existenz der Lieferung der Steuerspannung (Vccs) an die Abschaltdiagnoseeinheit (31) im ausgeschalteten Zustand anzeigt,
die Abschaltdiagnoseeinheit (31) so konfiguriert ist, dass sie eine Anomalie jeder der Abschaltschaltungen auf der Grundlage des Abschalt-Informationssignals (Det) diagnostiziert, das von den ersten bis vierten Schaltern (SW) erhalten wird, und
die Motorsteuervorrichtung (10, 50, 60, 70) Syntheseschaltungen (27pA, 27pB, 27nA, 27nB) umfasst, von denen jede so konfiguriert ist, dass sie das Diagnoseimpulssignal (Diag) vom Diagnoseimpulsgenerator (33) mit dem Notstoppbefehl logisch synthetisiert und Stoppsignale (Ssw P, Ssw N) an die jeweiligen ersten bis vierten Abschaltschaltungen (28pA, 28pB, 28nA, 28nB) ausgibt,
wobei die Abschaltschaltungen (28pA, 28pB, 28nA, 28nB) so konfiguriert sind, dass sie die Zufuhr der Betriebsstromversorgung zu den Antriebsschaltungen (23p, 23n) unterbrechen, wenn der Not-Aus-Befehl gegeben wird,
wobei eine Periode der Erzeugung der Diagnoseimpulssignale (Diag) innerhalb einer mittleren Zeit zwischen Ausfällen, MTBF, der ersten bis vierten Abschaltschaltungen (28pA, 28pB, 28nA, 28nB) durchgeführt wird.

2. Motorsteuervorrichtung nach Anspruch 1, die ferner umfasst:
Schalter (51, 52, 53, 54), von denen jeder so konfiguriert ist, dass er durch das Diagnoseimpulssignal des Diagnoseimpulsgenerators (33) ein- und ausgeschaltet wird und den Notausbefehl unterbricht,
wobei die Schalter (51, 52, 53, 54) so konfiguriert sind, dass sie den Not-Aus-Befehl in Übereinstimmung mit dem Diagnoseimpulssignal unterbrechen.

3. Motorsteuervorrichtung nach Anspruch 1, **dadurch gekennzeichnet, dass**
der Diagnoseimpulsgenerator (33) so konfiguriert ist, dass er in einem Fall, in dem die Abschaltdiagnoseeinheit (31) diagnostiziert, dass eine der Abschaltschaltungen (28pA, 28pB, 28nA, 28nB) anormal ist, ein Abschaltsignal an die erste bis vierte synthetische Schaltung (27pA, 27pB, 27nA, 27nB) ausgibt und ein Abnormalitätsbestimmungssignal ausgibt, das das PWM-Signal zum Treiben des Wechselrichters (24) stoppt.

4. Motorsteuervorrichtung nach Anspruch 1, **dadurch gekennzeichnet, dass**
der Not-Aus-Befehl dem PWM-Generator (22) zugeführt wird, und
wenn der Not-Aus-Befehl gegeben wird, der PWM-Generator (22) das PWM-Signal zur Ansteuerung des Wechselrichters (24) stoppt.

5. Motorsteuervorrichtung nach Anspruch 1 oder 4, bei der
die vier Abschaltkreise (28pA, 28pB, 28nA, 28nB) so konfiguriert sind, dass sie eine Spannungsversorgung entsprechend den Stoppsignalen (SswP, SswN) unterbrechen.

## Revendications

1. Dispositif de commande de moteur (10, 50, 60, 70) conçu pour commander l'entraînement d'un moteur (40) et ayant une fonction de coupure d'alimentation qui arrête l'alimentation du moteur (40) sous l'effet d'une commande d'arrêt d'urgence provenant de l'extérieur,
le dispositif de commande de moteur (10, 50, 60, 70) comprenant :
un dispositif de commande de rotation (21) conçu pour générer un signal de commande de rotation afin de commander un fonctionnement du moteur (40) en rotation,
un générateur de modulation de largeur d'impulsions (PWM, pulse width modulation) (22) conçu pour générer un signal PWM selon le signal de commande de rotation,
des circuits d'entraînement (23p, 23n) conçus pour émettre un signal d'impulsion d'entraînement qui commande l'activation ou la désactivation d'éléments de commutation (24p, 24n) selon le signal PWM,
un onduleur (24) possédant les éléments de commutation (24p, 24n) et conçu pour générer une tension appliquée au moteur (40) par commande PWM, les éléments de commutation (24p, 24n) étant activés ou désactivés selon le signal d'impulsion d'entraînement dans la commande PWM,
deux unités de coupure d'alimentation (30p, 30n) conçues respectivement avec deux lignes de circuits de coupure (28p, 28n) conçues pour couper la fourniture d'une alimentation de fonctionnement aux circuits d'entraînement (23p, 23n) selon une instruction ;
lesdits éléments de commutation (24p, 24n) de l'onduleur (24) présentant un élément de commutation côté P (24p) et un élément de commutation côté N (24n),
lesdits circuits d'entraînement (23p, 23n) comprenant un circuit d'entraînement côté P (23p) conçu pour commander l'activation ou la désactivation de l'élément de commutation côté P (24p) et un circuit d'entraînement côté N (23n) conçu pour commander l'activation ou la désactivation de l'élément de commutation côté N (24n), et
**caractérisé par**
un générateur d'impulsions de diagnostic (33) conçu pour générer des signaux d'impulsions de diagnostic (Diag) afin de diagnostiquer les circuits de coupure (28p, 28n) en commandant la coupure des circuits de coupure (28p, 28n), et
une unité de diagnostic de coupure (31) conçue pour détecter l'existence de la fourniture de l'alimentation de fonctionnement des circuits d'entraînement (23p, 23n),
l'unité de diagnostic de coupure (31) est conçue pour diagnostiquer, lorsque le générateur d'impulsions de diagnostic (33) émet un signal d'instruction de coupure en fonction du signal d'impulsion de diagnostic (Diag) aux circuits de coupure (28p, 28n), une anomalie des circuits de coupure (28p, 28n) en détectant l'existence de l'alimentation de fonctionnement des circuits d'entraînement (23p, 23n),
étant entendu que
les circuits de coupure (28p, 28n) comprennent des premier à quatrième circuits de coupure (28pA, 28pB, 28nA, 28nB),
le circuit d'entraînement côté P (23p) reçoit l'alimentation de fonctionnement du premier circuit de coupure (28pA) et du deuxième circuit de coupure (28pB),
le circuit d'entraînement côté N (23n) reçoit l'alimentation de fonctionnement du troisième circuit de coupure (28nA) et du quatrième circuit de coupure (28nB),
le générateur d'impulsions de diagnostic (33) est conçu pour générer périodiquement des premier à quatrième signaux d'impulsion de diagnostic (Diag) et est conçu pour émettre le premier et le deuxième signal d'impulsion de diagnostic (Diag) avec une différence de temps à destination des premier et deuxième circuits de coupure (28pA, 28pB) conçus pour fournir l'alimentation de fonctionnement au circuit d'entraînement côté P (23p), et émet les signaux d'impulsion de diagnostic avec une différence de temps à destination des troisième et quatrième circuits de coupure (28nA, 28nB) conçus pour fournir l'alimentation de fonctionnement au circuit d'entraînement côté N (23n), et
l'unité de diagnostic de coupure (31) est conçue pour diagnostiquer une anomalie des circuits de coupure (28pA, 28pB, 28nA, 28nB) en détectant l'existence d'une alimentation de fonctionnement à fournir par chacun des circuits de coupure (28pA, 28pB, 28nA, 28nB),
les premier à quatrième circuits de coupure (28pA, 28pB, 28nA, 28nB) comprennent respectivement des premier à quatrième commutateurs (SW) qui sont conçus pour fournir une tension de commande (Vccs) aux circuits d'entraînement (23p, 23n) à l'état d'activation et pour émettre un signal d'information de coupure (Det) indiquant un résultat de la détection de l'existence d'une fourniture de la tension de commande (Vccs) à l'unité de diagnostic de coupure (31) à l'état de désactivation,
l'unité de diagnostic de coupure (31) est conçue pour diagnostiquer une anomalie de chacun des circuits de coupure en fonction du signal d'information de coupure (Det) obtenu à partir des premier à quatrième commutateurs (SW), et
le dispositif de commande de moteur (10, 50, 60, 70) comprend des circuits de synthèse (27pA, 27pB, 27nA, 27nB) dont chacun est conçu pour synthétiser logiquement le signal d'impulsion de diagnostic (Diag) provenant du générateur d'impulsions de diagnostic (33) avec la commande d'arrêt d'urgence et pour émettre des signaux d'arrêt (S_{sw}P, S_{sw}N) à destination des premier à quatrième circuits de coupure (28pA, 28pB, 28nA, 28nB) respectifs,
les circuits de coupure (28pA, 28pB, 28nA, 28nB) étant conçus pour arrêter la fourniture de l'alimentation de fonctionnement auprès des circuits d'entraînement (23p, 23n) lorsque la commande d'arrêt d'urgence est donnée,
une période de génération des signaux d'impulsion de diagnostic (Diag) étant effectuée dans un temps moyen entre défaillances (MTBF, mean time between failures) des premier à quatrième circuits de coupure (28pA, 28pB, 28nA, 28nB).

2. Dispositif de commande de moteur selon la revendication 1, comprenant en outre :
des commutateurs (51, 52, 53, 54) dont chacun est conçu pour être activé ou désactivé par le signal d'impulsion de diagnostic provenant du générateur d'impulsions de diagnostic (33) et pour couper la commande d'arrêt d'urgence ;
lesdits commutateurs (51, 52, 53, 54) étant conçus pour couper la commande d'arrêt d'urgence en fonction du signal d'impulsion de diagnostic.

3. Dispositif de commande de moteur selon la revendication 1, dans lequel
le générateur d'impulsions de diagnostic (33) est conçu, dans un cas où l'unité de diagnostic de coupure (31) diagnostique que l'un quelconque des circuits de coupure (28pA, 28pB, 28nA, 28nB) est anormal, pour émettre un signal de coupure à destination des premier à quatrième circuits synthétiques (27pA, 27pB, 27nA, 27nB) et pour émettre un signal de détermination d'anomalie qui arrête le signal PWM pour entraîner l'onduleur (24).

4. Dispositif de commande de moteur selon la revendication 1, dans lequel
la commande d'arrêt d'urgence est fournie au générateur PWM (22), et
dans un cas où la commande d'arrêt d'urgence est donnée, le générateur PWM (22) arrête le signal PWM pour entraîner l'onduleur (24).

5. Dispositif de commande de moteur selon les revendications 1 ou 4, dans lequel
les quatre circuits de coupure (28pA, 28pB, 28nA, 28nB) sont conçus pour couper la fourniture en tension selon les signaux d'arrêt (SswP, SswN).
